# EUROPEAN PATENT SPECIFICATION

(11) **EP 3 014 671 B1**
(45) Date of publication and mention of the grant of the patent: **24.05.2023**
(21) Application number: 14818730.5
(22) Date of filing: 27.06.2014
(51) Int. Cl.: H10K 30/88, H10K 77/10, B32B 37/12, B29C 63/02

(54) **AIRCRAFT FUSELAGE SURFACE WITH ORGANIC PHOTOVOLTAIC DEVICE**
FLUGZEUGRUMPFOBERFLÄCHE MIT ORGANISCHER FOTOVOLTAISCHER ANORDNUNG
SURFACE DE FUSELAGE D'AVION AVEC DISPOSITIF PHOTOVOLTAÏQUE ORGANIQUE

(30) Priority: 28.06.2013 US 201361841248 P; 28.06.2013 US 201361841244 P; 28.06.2013 US 201361841243 P; 28.06.2013 US 201361841251 P; 28.06.2013 US 201361841247 P; 02.07.2013 US 201361842365 P; 02.07.2013 US 201361842357 P; 02.07.2013 US 201361842355 P; 02.07.2013 US 201361842372 P; 02.07.2013 US 201361842375 P; 03.07.2013 US 201361842803 P; 03.07.2013 US 201361842796 P
(43) Date of publication of application: 04.05.2016
(73) Proprietor: SolarWindow Technologies, Inc., Scottsdale, AZ 85260 (US)
(72) Inventor: CONKLIN, John, Anthony, Apalachin, NY 13732 (US); HAMMOND, Scott, Ryan, Wheat Ridge, CO 80215 (US); THOMPSON, J., Patrick, Canton, GA 30114 (US)
(74) Representative: Murgitroyd & Company
(86) International application number: PCT/US2014/044650
(87) International publication number: WO 2014/210505

(56) References cited:
- WO-A1-00/59035
- WO-A1-2012/078517
- WO-A2-2012/101207
- US-A1- 2006 130 894
- US-A1- 2010 116 927
- US-A1- 2010 116 927
- US-A1- 2011 277 809
- US-A1- 2012 012 180
- US-A1- 2013 002 015
- US-A1- 2013 002 015
- KALTENBRUNNER M ET AL: "Ultrathin and lightweight organic solar cells with high flexibility", NATURE COMMUNICATIONS, NATURE PUBLISHING GROUP, UNITED KINGDOM , 1 April 2012 (2012-04-01), pages 1-7, XP002682520, ISSN: 2041-1723, DOI: 10.1038/NCOMMS1772 Retrieved from the Internet: URL:http://www.nature.com/ncomms/journal/v 3/n4/full/ncomms1772.html [retrieved on 2012-04-03]

## Description

### FIELD OF THE INVENTION

The present invention is directed to the use of organic photovoltaic devices - cell or modules - as coatings for aircraft fuselage panel surfaces e.g., wing, tail, and strut surfaces, to provide electricity for mission-critical systems and/or maintenance loads on-board the aircraft.

### BACKGROUND OF THE INVENTION

Modern commercial aircraft are becoming increasingly technologically advanced vehicles that must operate effectively under demanding conditions. Energy efficiency and energy consumption are of increasing importance in such vehicles, as airlines and society become more concerned with both the economics and the climate impact of air travel.

Document US 2013/002015 A1 discloses a self-sufficient supplementary power supply for supplying power to ohmic consumer e.g. braking system, of e.g. long-range solar-driven aircraft.

### SUMMARY OF THE INVENTION

The present invention provides an aircraft fuselage panel surface comprising an electricity-generating optical photovoltaic (OPV) device laminated to the aircraft fuselage panel surface and a method of laminating the OPV device to the aircraft fuselage panel surface as defined in the claims.

The present invention recognizes that one way to increase energy efficiency is to incorporate renewable energy sources, but of the traditional renewable energy sources, photovoltaics (PV) is the only one that makes sense for aircraft. Electricity from PV could be used to help power mission-critical systems and/or maintenance loads on-board commercial aircraft to offset the energy needs of the many electrical systems present in modern aircraft. Traditional inorganic PV makes little sense for aircraft applications for a number of reasons, however, including excessive weight and potentially bulky structures that could increase wind resistance, both of which would reduce fuel efficiency, and poor aesthetics.

Organic PV (OPV) has a number of features that makes it potentially attractive for application in commercial aircraft including low specific weight (W/g), flexibility, and thickness of the thin films. An important feature is the very low specific weight of OPV, as compared to other PV technologies, which could minimize any impact on fuel efficiency. Additionally, because OPV is inherently flexible, this device architecture potentially allows unique application methods for non-planar surfaces, such as curved fuselage surfaces. Furthermore, the tunable nature of the absorption in OPV materials allows for customized surface appearances, which can be desirable for power production, and aesthetic and branding reasons.

The present invention recognizes that conventional commercial aircraft surfaces, such as fuselage, wing, tail, and strut surfaces (hereafter referred to simply as fuselage surfaces), are generally large passive surfaces that do not contribute in any way to help increase energy efficiency of the aircraft.

These problems and others are addressed by the present invention, a first exemplary embodiment not within the scope of the invention as claimed comprising an OPV device, comprising one or more cells connected in series and/or parallel, applied as a film to conventional commercial aircraft surfaces. In this embodiment, the OPV coating is applied as a completed device onto the aircraft surface using a thin, flexible substrate with pressure-sensitive adhesives, which is described in detail in Applicants' related applications. In such a fashion, the OPV device can be fabricated in a high-throughput manner via roll-to-roll or sheet-to-sheet manufacturing processes onto a flexible planar substrate (with backing material, if necessary) that is then applied to both planar and curved aircraft surfaces. The OPV device can then be wired into the electrical systems via small connection terminals in, or below, the aircraft surface, and any necessary power electronics, such as inverters, batteries, and the like can be located inside the aircraft body. The top surface of the OPV device-coated aircraft is then protected via a hard clear-coat, (e.g. a clear epoxy coating), to protect the OPV device from physical damage and environmental stresses, and from moisture and oxygen ingress, ensuring a superior lifetime. In such a way, the surfaces of the aircraft can be turned into electricity-generating surfaces to help power mission-critical systems and/or maintenance loads, while adding minimal weight, and resulting in a smooth, hard, low-drag surface, to minimize any loss of fuel efficiency. Furthermore, by selecting appropriate OPV material absorption properties, the surface visual effect can be customized for specific levels of power production, and aesthetic or branding reasons, while still generating power.

Another exemplary embodiment also not within the scope of the invention as claimed comprises an OPV device - comprising one or more cells connected in series and/or parallel - fabricated directly on the conventional aircraft surfaces, before assembly of the aircraft. In this embodiment, the surfaces are coated via one or more of a number of coating techniques, such techniques as: spray, curtain , slot-die, gravure, etc. depending on the curvature of the aircraft surface requiring OPV. Spray and curtain coating can be utilized for curved surfaces, while slot-die and gravure coating can be used for planar surfaces. First, an insulating layer is deposited to allow isolation of the individual cells from each other and from the metal aircraft surfaces, to prevent electrification of the entire aircraft body. Then, the rest of the OPV device is deposited as usual via the appropriate coating and patterning techniques, as know to those skilled in the art of OPV, to produce a completed device directly on the aircraft surface. Again, wiring is accomplished via small terminals on, or below, the aircraft surface, and a hard top-coat, such as an epoxy, is applied to provide a hard, low-drag surface that protects the OPV device. Such completed OPV-coated aircraft surface panels can then be assembled directly on the aircraft body, with wiring and any necessary power electronics such as inverters and batteries placed inside the aircraft body, to produce a commercial aircraft with electricity-producing surfaces to help power mission-critical systems and/or maintenance loads on-board, increasing energy efficiency of the aircraft.

Other features and advantages of the present invention will become apparent to those skilled in the art upon review of the following detailed description and drawings.

### BRIEF DESCRIPTION OF THE DRAWINGS

These and other aspects and features of embodiments of the present invention will be better understood after a reading of the following detailed description, together with the attached drawings, wherein:
Figure 1 is a cross-sectional view of a pressure-sensitive adhesive-coated organic photovoltaic device, itself coated on a thin flexible substrate with a transfer release layer and rigid backing layer, which can be used to prepare planar and curved organic photovoltaic devicecovered commercial aircraft fuselage surfaces, according to an exemplary embodiment not within the scope of the invention as claimed.
Figure 2 is a cross-sectional view of an organic photovoltaic device coated onto a planar commercial aircraft fuselage surface using the pressure-sensitive adhesive method according to the invention.
Figure 3 is a cross-sectional view of an organic photovoltaic device coated onto a curved commercial aircraft fuselage surface using the pressure-sensitive adhesive method according to another embodiment of the invention.
Figure 4 is a cross-sectional view of an organic photovoltaic device coated directly onto a planar commercial aircraft fuselage surface using conventional coating methods according to another embodiment of the invention.
Figure 5 is a cross-sectional view of an organic photovoltaic device coated directly onto a curved commercial aircraft fuselage surface using conventional coating methods according to another embodiment of the invention.

### DETAILED DESCRIPTION OF THE EXEMPLARY EMBODIMENTS OF THE INVENTION

The present invention now is described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

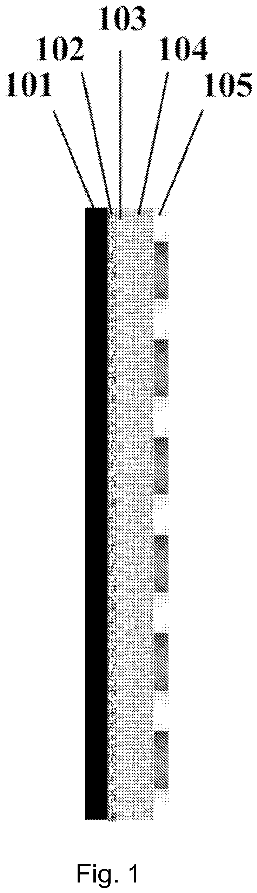

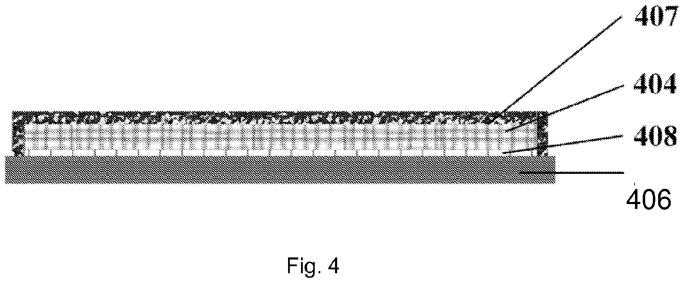

Referring now to the drawings, Figures 1-5 illustrate exemplary embodiments of electricity-generating coatings for commercial aircraft fuselage surfaces (Figures 4-5) and their manufacture (Figure 1).

Referring to Fig. 1, which provides a cross-sectional view of an intermediate film stack produced for the eventual fabrication of electricity-generating coatings for commercial aircraft fuselage surfaces, the film is prepared upon a temporary base layer 101, in order to provide sufficient rigidity to allow conventional manufacturing techniques, including high-speed roll-to-roll coating. The base layer can include of thick polymer foils, metal foils, or any convenient substrate material, depending on the chosen manufacturing methods. On top of the base layer is a transfer release layer 102 that allows easy removal of the base layer and transfer layer from the thin flexible substrate 103, which are all laminated together as known to those skilled in the art. The thin flexible substrate is any appropriate substrate material that is highly flexible and transparent, such as very thin polymer foils, including but not limited to polyethyleneterephthalate (PET). On top of this is coated an OPV device, comprising one or more cells connected in series and/or parallel, which is inherently flexible and thus contains no highly crystalline materials. The multi-layered OPV device is coated and processed according to standard methods known to those skilled in the art, such as slot-die coating and laser scribing, which are compatible with high-throughput manufacturing techniques, including high-speed roll-to-roll or sheet-to-sheet production methods. Finally, the OPV device is coated on top with a semitransparent pressure-sensitive adhesive according to methods know to those skilled in the art. The resulting film comprising layers 101-105 can be used to transfer the OPV device comprising layers 103-105 onto commercial aircraft fuselage surfaces to convert them into electricity-generating fuselage surfaces.

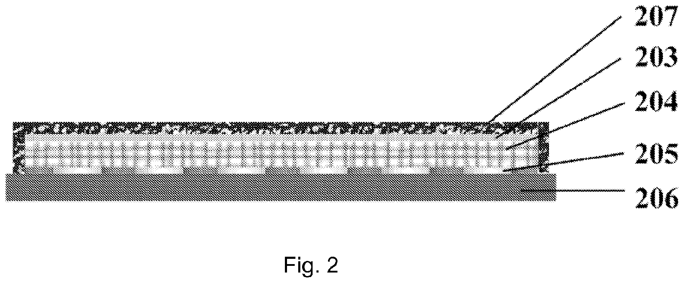

Referring to Fig. 2, which provides a cross-sectional view of a planar electricity-generating commercial aircraft fuselage surface produced via the pressure-sensitive adhesive method, the base layer 206 includes a conventional commercial aircraft fuselage panel. Laminated onto the fuselage panel using stretching and press-forming, with or without vacuum assistance in removing entrained air, is the electricity-generating OPV device 204, which is adhered to the panel using the pressure-sensitive adhesive layer 205, and is supported by the thin flexible substrate layer 203. Finally, the whole OPV device is protected via a clear hard-coat 207 (e.g. a clear epoxy), which can be applied via a variety of techniques known to those skilled in the art, such as spray coating. While, in this exemplary embodiment, the method is necessarily a discrete object process for the fabrication of each individual fuselage panel, the intermediate transfer film (see Fig. 1) used to transfer the completed OPV device onto the panel can be produced in a continuous, high-throughput methodology. Not shown are any wires or other electrical contacts, or any power circuitry (e.g. inverters), which would be contained largely within the aircraft body.

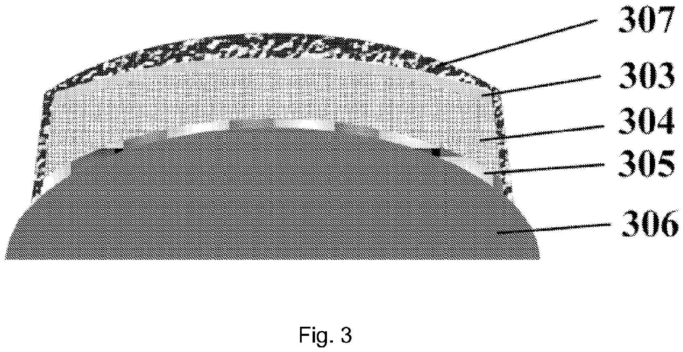

Referring to Fig. 3, which provides a cross-sectional view of a curved electricity-generating commercial aircraft fuselage surface produced via the pressure-sensitive adhesive method, the base layer 306 includes a conventional curved commercial aircraft fuselage surface. Laminated onto the fuselage panel using stretching and press-forming, with or without vacuum assistance in removing entrained air, is the electricity-generating OPV device 304, which is adhered to the panel using the pressure-sensitive adhesive layer 305, and is supported by the thin flexible substrate layer 303. Finally, the whole OPV device is protected via a clear hard-coat 307 (e.g. a clear epoxy), which can be applied via a variety of techniques known to those skilled in the art, such as spray coating. The unique and inherent flexibility of OPV devices allows lamination onto curved surfaces without significant disruption of device performance, and enables production of three-dimensional OPV devices that would be difficult to produce via conventional coating techniques due to realities of capillarity flow on curved surfaces. This method enables OPV devices to be laminated onto surfaces of arbitrary and changing curvature, which would be impossible via conventional solution coating techniques. While, in this exemplary embodiment, the method is necessarily a discrete object process for the fabrication of each individual fuselage panel, the intermediate transfer film (see Fig. 1) used to transfer the completed OPV device onto the panel can be produced in a continuous, high-throughput methodology. Not shown are any wires or other electrical contacts, or any power circuitry (e.g. inverters), which would be contained largely within the aircraft body.

Referring to Fig. 4, which provides a cross-sectional view of a planar electricity-generating commercial aircraft fuselage surface produced via the conventional coating method, the base layer 406 includes a conventional commercial aircraft fuselage surface. First, the fuselage surface is coated with an insulating layer 408 using methods known to those skilled in the art, to allow isolation of the individual cells from each other and from the aircraft body, preventing electrification of the entire aircraft body. The OPV device 404 is then coated onto the insulating layer using conventional coating techniques such as known to those skilled in the art. Finally, the whole OPV device is protected via a clear hard-coat 407 (e.g. a clear epoxy), which can be applied via a variety of techniques known to those skilled in the art, such as spray coating. While this method has the advantage of having less extraneous layers and materials involved as compared to the laminated processes (see Fig. 2), in this exemplary embodiment, it is necessarily a sheet-to-sheet coating process performed on a panel-by-panel basis for every individual layer in the OPV device, which can limit throughput and increase defects, compared to producing the OPV device in a continuous process (see Fig. 1). Not shown are any wires or other electrical contacts, or any power circuitry (e.g. inverters), which would be contained largely within the aircraft body.

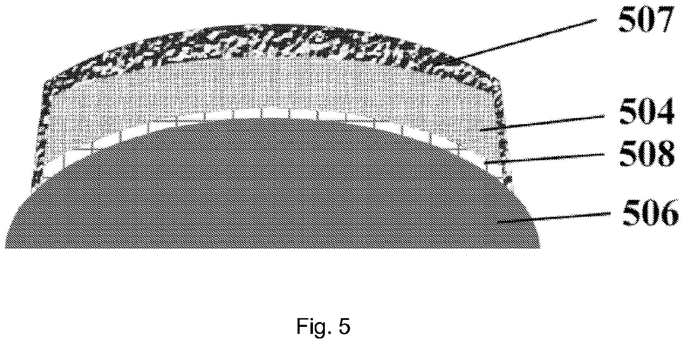

Referring to Fig. 5, which provides a cross-sectional view of a curved electricity-generating commercial aircraft fuselage surface produced via the conventional coating method, the base layer 506 includes a conventional commercial aircraft fuselage surface. First, the fuselage surface is coated with an insulating layer 508 using methods known to those skilled in the art, to allow isolation of the individual cells from each other and from the aircraft body, preventing electrification of the entire aircraft body. The OPV device 504 is then coated onto the insulating layer using conventional coating techniques such as spray or curtain coating. Finally, the whole OPV device is protected via a clear hard-coat 507 (e.g. a clear epoxy), which can be applied via a variety of techniques known to those skilled in the art, such as spray coating. While the realities of capillarity flow make precision coating of the very thin layers in OPV devices very difficult, it is possible to overcome these limitations, as least for surfaces with relatively uniform curvature. Doing so repeated for the several layers in an OPV device remains a significant challenge, however, and it is currently impossible for surfaces with varying or very high curvature. As such, the pressure-sensitive adhesive lamination method presents an attractive alternative for the production of curved fuselage surfaces (see Fig. 3).

## Claims

1. An aircraft fuselage panel surface (206, 306, 406, 506) comprising an electricity-generating organic photovoltaic (OPV) device laminated to the aircraft fuselage panel surface, wherein the OPV device includes:
a support substrate (101),
a thin, flexible transparent substrate (103),
a transfer release layer (102) laminated between the support substrate and the thin, flexibletransparent substrate,
an OPV device layer (104, 204, 304, 404, 504) coated on the transfer release layer, wherein the OPV device layer (104, 204, 304, 404, 504, 604), comprises one or more cells connected in series and/or parallel, and
a pressure-sensitive adhesive (105, 205, 305, 405, 505) coating on the OPV device layer (104, 204, 304, 404, 504),
wherein the pressure-sensitive adhesive is configured to adhere and conform the support substrate, the transfer release layer, the thin, flexible transparent substrate, and the OPV device layer to the aircraft fuselage panel surface,
wherein the support substrate and the transfer release layer are configured to be removable from the thin, flexible transparent substrate such that components of the thin, flexible transparent substrate, the OPV device layer, and the pressure-sensitive adhesive remain on the aircraft fuselage panel surface after the support substrate and the transfer release layer have been removed, and
wherein the pressure-sensitive adhesive is semitransparent.

2. The aircraft fuselage panel surface of claim 1, wherein the support substrate is a rigid material.

3. The aircraft fuselage panel surface of claim 1, wherein the support substrate is a flexible material.

4. The aircraft fuselage panel surface of claim 1, 2 or 3, wherein the OPV device layer is multi-layered.

5. A method of laminating an electricity-generating organic photovoltaic (OPV) device (204, 304, 404, 504) to an aircraft fuselage panel surface, wherein the method comprises:
applying the organic photovoltaic device including one or more cells connected in series and/or parallel, to an aircraft fuselage panel surface, along with wires and power electronics to allow such coatings to provide electricity for mission-critical systems and/or maintenance loads on-board the aircraft, wherein the organic photovoltaic device comprises:
a support substrate (101),
a thin, flexible transparent substrate (103),
a transfer release layer (102) laminated between the support substrate and the thin, flexibletransparent substrate,
an OPV device layer (104, 204, 304, 404, 504) coated on the transfer release layer, wherein the OPV device (104, 204, 304, 404, 504, 604), comprises one or more cells connected in series and/or parallel, and
a pressure-sensitive adhesive (105, 205, 305, 405, 505) coating on the OPV device layer (104, 204, 304, 404, 504),
wherein the method comprises:
applying the OPV device with the pressure sensitive adhesive towards the aircraft fuselage panel surface;
utilizing lamination, stretching, press-forming, and/or vacuum removal of air entrainment to ensure conformal adhesion, and
removing the support substrate and the transfer release layer.

6. The method of claim 5, comprising the further step of applying a clear coat (207) to the OPV device after removing the support substrate and the transfer release layer.

7. The method of claim 5 or 6, wherein the support substrate is a rigid material.

8. The method of claim 5 or 6, wherein the support substrate is a flexible material.

9. The method of claims 5 to 8, wherein the OPV device layer is multi-layered.

## Patentansprüche

1. Eine Flugzeugrumpfplatten-Oberfläche (206, 306, 406, 506), die eine stromerzeugende organische photovoltaische Anordnung (OPV-Anordnung), die auf die Flugzeugrumpfplatten-Oberfläche laminiert ist, beinhaltet, wobei die OPV-Anordnung Folgendes umfasst:
ein Trägersubstrat (101),
ein dünnes, flexibles transparentes Substrat (103),
eine Übertragungstrennschicht (102), die zwischen das Trägersubstrat und das dünne, flexible transparente Substrat laminiert ist,
eine OPV-Anordnungsschicht (104, 204, 304, 404, 504), die auf die Übertragungstrennschicht aufbeschichtet ist, wobei die OPV-Anordnungsschicht (104, 204, 304, 404, 504, 604) eine oder mehrere in Reihe und/oder parallel geschaltete Zellen beinhaltet, und
eine Beschichtung aus Haftklebstoff (105, 205, 305, 405, 505) auf der OPV-Anordnungsschicht (104, 204, 304, 404, 504),
wobei der Haftklebstoff konfiguriert ist, um das Trägersubstrat, die Übertragungstrennschicht, das dünne, flexible transparente Substrat und die OPV-Anordnungsschicht an die Flugzeugrumpfplatten-Oberfläche zu kleben und mit dieser konform zu machen,
wobei das Trägersubstrat und die Übertragungstrennschicht konfiguriert sind, um von dem dünnen, flexiblen transparenten Substrat entfernbar zu sein, sodass Komponenten des dünnen, flexiblen transparenten Substrats, der OPV-Anordnungsschicht und des Haftklebstoffs auf der Flugzeugrumpfplatten-Oberfläche verbleiben, nachdem das Trägersubstrat und die Übertragungstrennschicht entfernt worden sind, und
wobei der Haftklebstoff halbtransparent ist.

2. Flugzeugrumpfplatten-Oberfläche gemäß Anspruch 1, wobei das Trägersubstrat ein steifes Material ist.

3. Flugzeugrumpfplatten-Oberfläche gemäß Anspruch 1, wobei das Trägersubstrat ein flexibles Material ist.

4. Flugzeugrumpfplatten-Oberfläche gemäß Anspruch 1, 2 oder 3, wobei die OPV-Anordnungsschicht mehrschichtig ist.

5. Ein Verfahren zum Laminieren einer stromerzeugenden organischen photovoltaischen Anordnung (OPV-Anordnung) (204, 304, 404, 504) auf eine Flugzeugrumpfplatten-Oberfläche, wobei das Verfahren Folgendes beinhaltet:
Aufbringen der organischen photovoltaischen Anordnung, die eine oder mehrere in Reihe und/oder parallel geschaltete Zellen umfasst, auf eine Flugzeugrumpfplatten-Oberfläche, zusammen mit Leitungen und Leistungselektronik, um solchen Beschichtungen zu gestatten, Strom für missionskritische Systeme und/oder Wartungslasten an Bord des Flugzeugs bereitzustellen, wobei die organische photovoltaische Anordnung Folgendes beinhaltet:
ein Trägersubstrat (101),
ein dünnes, flexibles transparentes Substrat (103),
eine Übertragungstrennschicht (102), die zwischen das Trägersubstrat und das dünne, flexible transparente Substrat laminiert ist,
eine OPV-Anordnungsschicht (104, 204, 304, 404, 504), die auf die Übertragungstrennschicht aufbeschichtet ist, wobei die OPV-Anordnung (104, 204, 304, 404, 504, 604) eine oder mehrere in Reihe und/oder parallel geschaltete Zellen beinhaltet, und
eine Beschichtung aus Haftklebstoff (105, 205, 305, 405, 505) auf der OPV-Anordnungsschicht (104, 204, 304, 404, 504),
wobei das Verfahren Folgendes beinhaltet:
Aufbringen der OPV-Anordnung mit dem Haftklebstoff in Richtung der Flugzeugrumpfplatten-Oberfläche;
Verwenden von Laminierung, Streckziehen, Pressformen und/oder Vakuumentfernung von Lufteintrag, um konformes Kleben zu gewährleisten, und
Entfernen des Trägersubstrats und der Übertragungstrennschicht.

6. Verfahren gemäß Anspruch 5, das den weiteren Schritt des Aufbringens einer klaren Beschichtung (207) auf die OPV-Anordnung nach dem Entfernen des Trägersubstrats und der Übertragungstrennschicht beinhaltet.

7. Verfahren gemäß Anspruch 5 oder 6, wobei das Trägersubstrat ein steifes Material ist.

8. Verfahren gemäß Anspruch 5 oder 6, wobei das Trägersubstrat ein flexibles Material ist.

9. Verfahren gemäß den Ansprüchen 5 bis 8, wobei die OPV-Anordnungsschicht mehrschichtig ist.

## Revendications

1. Une surface de panneau de fuselage d'aéronef (206, 306, 406, 506) comprenant un dispositif photovoltaïque organique (OPV) électrogène plaqué sur la surface de panneau de fuselage d'aéronef, dans laquelle le dispositif OPV inclut :
un substrat de support (101),
un substrat transparent flexible mince (103),
une couche de séparation et transfert (102) stratifiée entre le substrat de support et le substrat transparent flexible mince,
une couche de dispositif OPV (104, 204, 304, 404, 504) déposée sur la couche de séparation et transfert, la couche de dispositif OPV (104, 204, 304, 404, 504, 604) comprenant une ou plusieurs cellules connectées en série et/ou en parallèle, et
un revêtement d'adhésif sensible à la pression (105, 205, 305, 405, 505) sur la couche de dispositif OPV (104, 204, 304, 404, 504),
dans laquelle l'adhésif sensible à la pression est configuré pour amener le substrat de support, la couche de séparation et transfert, le substrat transparent flexible mince, et la couche de dispositif OPV à adhérer et à se conformer à la surface de panneau de fuselage d'aéronef,
dans laquelle le substrat de support et la couche de séparation et transfert sont configurés pour pouvoir être retirés du substrat transparent flexible mince de telle sorte que des constituants du substrat transparent flexible mince, de la couche de dispositif OPV, et de l'adhésif sensible à la pression restent sur la surface de panneau de fuselage d'aéronef après que le substrat de support et la couche de séparation et
transfert ont été retirés, et
dans laquelle l'adhésif sensible à la pression est semi-transparent.

2. La surface de panneau de fuselage d'aéronef de la revendication 1, dans laquelle le substrat de support est un matériau rigide.

3. La surface de panneau de fuselage d'aéronef de la revendication 1, dans laquelle le substrat de support est un matériau flexible.

4. La surface de panneau de fuselage d'aéronef de la revendication 1, de la revendication 2 ou de la revendication 3, dans laquelle la couche de dispositif OPV est multicouche.

5. Un procédé de placage d'un dispositif photovoltaïque organique (OPV) électrogène (204, 304, 404, 504) sur une surface de panneau de fuselage d'aéronef, le procédé comprenant :
le fait d'appliquer le dispositif photovoltaïque organique incluant une ou plusieurs cellules connectées en série et/ou en parallèle, sur une surface de panneau de fuselage d'aéronef, conjointement avec des fils et dispositifs électroniques de puissance destinés à permettre à de tels revêtements de fournir de l'électricité pour des systèmes essentiels à une mission et/ou des charges d'entretien à bord de l'aéronef,
dans lequel le dispositif photovoltaïque organique comprend :
un substrat de support (101),
un substrat transparent flexible mince (103),
une couche de séparation et transfert (102) stratifiée entre le substrat de support et le substrat transparent flexible mince,
une couche de dispositif OPV (104, 204, 304, 404, 504) déposée sur la couche de séparation et transfert, le dispositif OPV (104, 204, 304, 404, 504, 604) comprenant une ou plusieurs cellules connectées en série et/ou en parallèle, et un revêtement d'adhésif sensible à la pression (105, 205, 305, 405, 505) sur la couche de dispositif OPV (104, 204, 304, 404, 504),
le procédé comprenant :
le fait d'appliquer le dispositif OPV avec l'adhésif sensible à la pression tourné vers la surface de panneau de fuselage d'aéronef ;
le fait d'utiliser placage, étirement, estampage, et/ou élimination sous vide d'entraînement d'air afin d'assurer une adhésion conforme, et
le fait de retirer le substrat de support et la couche de séparation et transfert.

6. Le procédé de la revendication 5, comprenant l'étape supplémentaire consistant à appliquer un revêtement incolore (207) sur le dispositif OPV après avoir retiré le substrat de support et la couche de séparation et transfert.

7. Le procédé de la revendication 5 ou de la revendication 6, dans lequel le substrat de support est un matériau rigide.

8. Le procédé de la revendication 5 ou de la revendication 6, dans lequel le substrat de support est un matériau flexible.

9. Le procédé des revendications 5 à 8, dans lequel la couche de dispositif OPV est multicouche.
